# FASCICULE DE BREVET EUROPEEN

(11) **EP 3 184 485 B1**
(45) Date de publication et mention de la délivrance du brevet: **09.05.2018**
(21) Numéro de dépôt: 16206511.4
(22) Date de dépôt: 22.12.2016
(51) Int. Cl.: B81B 7/04, H03H 3/02

(54) **SYSTEME PRESENTANT UNE DENSITE SURFACIQUE DE DISPOSITIFS MICROELECTROMECANIQUES ET/OU NANOELECTROMECANIQUES AUGMENTEE**
SYSTEM MIT EINER ERHÖHTEN OBERFLÄCHENDICHTE VON MIKROELEKTROMECHANISCHEN UND/ODER NANOELEKTROMECHANISCHEN VORRICHTUNGEN
SYSTEM HAVING AN INCREASED SURFACE DENSITY OF MICROELECTROMECHANICAL AND/OR NANOELECTROMECHANICAL DEVICES

(30) Priorité: 24.12.2015 FR 1563325
(43) Date de publication de la demande: 28.06.2017
(73) Titulaire: COMMISSARIAT À L'ÉNERGIE ATOMIQUE ET AUX ÉNERGIES ALTERNATIVES, 75015 Paris (FR)
(72) Inventeur: LUDURCZAK, Willy, 69006 Lyon (FR); HENTZ, Sébastien, 38170 Seyssinet-Pariset (FR)
(74) Mandataire: Brevalex

(56) Documents cités:
- FR-A1- 2 996 219
- US-A1- 2011 298 553
- SAGE E ET AL: "Frequency-addressed NEMS arrays for mass and gas sensing applications", 2013 TRANSDUCERS & EUROSENSORS XXVII: THE 17TH INTERNATIONAL CONFERENCE ON SOLID-STATE SENSORS, ACTUATORS AND MICROSYSTEMS (TRANSDUCERS & EUROSENSORS XXVII), IEEE, 16 juin 2013 (2013-06-16), pages 665-668, XP032499609, DOI: 10.1109/TRANSDUCERS.2013.6626854

## Description

### DOMAINE TECHNIQUE ET ÉTAT DE LA TECHNIQUE ANTÉRIEURE

La présente invention se rapporte à un système comportent une densité surfacique augmentée de dispositifs microélectromécaniques et/ou nanoélectromécaniques, et en particulier à un système d'analyse offrant une limite de détection abaissée.

Les dispositifs microélectromécaniques et/ou MEMS (Microelectromechanical systems en terminologie anglo-saxonne) et les dispositifs nanoélectromécaniques ou NEMS (Nanoelectromechanical systems en terminologie anglo-saxonne), notamment les dispositifs MEMS et/ou NEMS de type résonateur, peuvent être utilisés comme capteurs pour effectuer l'analyse d'un milieu liquide ou gazeux.

Ces dispositifs MEMS et/ou NEMS sont par exemple utilisés comme capteur de gaz, comme capteurs biologiques pour détecter la présence de cellules biologiques dans un milieu liquide, ou comme spectromètre de masse. On cherche de manière générale à abaisser leur limite de détection afin de quantifier le plus précisément possible la quantité de matière mesurée et afin de détecter des espèces très fortement dispersées ou diluées dans un grand volume d'un élément porteur tel un gaz ou mélange gazeux ou un liquide.

Dans le cas des capteurs de gaz, le dispositif MEMS et/ou NEMS comporte une zone d'interaction qui peut être munie d'une couche de fonctionnalisation ayant une affinité chimique particulière envers certaines espèces à mesurer : les particules sont alors absorbées sur la zone d'interaction de manière homogène sur toute la surface de la zone d'interaction. Lorsque la concentration à mesurer devient très faible, la probabilité de capture des espèces par la zone d'interaction qui présente une surface réduite, notamment dans le cas d'un NEMS, devient très faible.

Afin d'augmenter cette probabilité on a recours à l'utilisation de réseaux de MEMS et/ou NEMS collectivement adressés afin de bénéficier de la très bonne sensibilité des résonateurs, mais aussi d'une grande surface de capture.

Dans le cas d'un capteur biologique, le dispositif résonant est placé en milieu liquide contenant les cellules biologiques à détecter. Il se peut que l'on soit amené à détecter les cellules de manière individuelle dans le cas où leur concentration est très faible. Afin d'offrir une grande surface de capture, des réseaux de résonateurs, les résonateurs étant individuellement adressés ou non, peuvent être utilisés.

Dans le cas de la spectroscopie de masse mettant en oeuvre un NEMS, on cherche à mesurer la masse de chaque particule (par exemple biologique) d'un mélange initialement en phase liquide qu'on vient projeter sur le NEMS sous vide, afin de remonter au spectre en masse du contenu du mélange pour des applications biomédicales d'identification par exemple. Ce système utilise un seul NEMS pour détecter les particules projetées sur sa surface, d'environ 1 µm², alors que le faisceau de particules, suivant le type de système d'injection peut avoir une aire projetée de quelques mm² à quelques cm². Un problème additionnel peut se poser en spectroscopie de masse par rapport aux deux applications précédentes : il s'agit ici de mesurer la masse d'une particule ponctuelle ou en tout cas plus petite que la surface du résonateur et non répartie sur celle-ci. Or le décalage en fréquence induit par l'ajout d'une particule dépend non seulement de sa masse, mais aussi de sa position d'arrivée sur le résonateur. Il est donc nécessaire de mesurer en temps réel non plus une seule fréquence de résonance, mais plusieurs fréquences de résonance

Par exemple, on peut être amené à vouloir détecter une cellule de l'ordre de 10 à 100 nm sur une surface de 1 mm². Une densité de par exemple 1000 NEMS/ mm² peut alors être requise.

Le document *"*FREQUENCY-ADDRESSED NEMS ARRAYS FOR MASS AND GAS SENSING APPLICATIONS", E. Sage, O. Martin, C.Dupré, T.Ernst, G.Billiot, L.Duraffourg, E. Colinet and S. Hentz, CEA, LETI, MINATEC Campus, 17 rue des Martyrs, 38054 GRENOBLE Cedex 9, France. Transducers 2013 16/06/2013 - 20/06/2013 Barcelone Espagne décrit un réseau dans lequel les NEMS sont interconnectés en parallèle et sont adressés de manière fréquentielle. Chaque NEMS a sa propre fréquence de résonance, ce qui permet de le distinguer des autres NEMS et de pouvoir les connecter en parallèle. Chaque NEMS comporte plusieurs bornes permettant l'excitation de la partie résonante, la polarisation du NEMS et la collecte des signaux. Chaque borne d'un NEMS est reliée par une piste de connexion à un contact. Il en résulte que toutes les bornes ayant la même fonction sont reliées à un contact par une piste de connexion. Autant de pistes de connexion que de bornes sont donc requises.

La réalisation de telles pistes de connexion est consommateur de place ce qui a pour effet de limiter la densité de NEMS, en outre le procédé de réalisation est complexe. Le document US 2011/298553 A1 divulgue un système nanoélectronique comportant deux résonateurs disposés de telle sorte que l'emplacement géométrique d'une des bornes électriques du premier résonateur est identique à l'emplacement géométrique d'une borne du second résonateur.

### EXPOSÉ DE L'INVENTION

C'est par conséquent un but de la présente invention d'offrir un système comportant une densité surfacique de dispositifs MEMS et/ou NEMS augmentée par rapport aux systèmes de l'état de la technique.

Le but énoncé ci-dessus est atteint par un système comportant une pluralité de dispositifs MEMS et/ou NEMS comprenant chacun une zone d'interaction et des bornes de connexion vers l'extérieur, au moins deux bornes de deux dispositifs MEMS et/ou NEMS adjacent ayant le même emplacement géométrique de sorte que les bornes soient confondues.

De préférence, tous les dispositifs MEMS et/ou NEMS ont le même nombre de bornes et ont tous la même disposition relative des bornes par rapport à la zone d'interaction.

Dans la présente demande on entend par « zone d'interaction », une zone apte soit interagir avec l'environnement extérieur, par exemple en absorbant une ou des particules, ou en échangeant thermiquement avec le milieu environnant dans le cas d'une mise en oeuvre dans un système d'analyse, soit comme actionneur.

L'encombrement est réduit par rapport au système de l'état de la technique dans lequel chaque NEMS a ses propres bornes, les bornes étant reliées par des connexions électriques à un contact commun.

En d'autres termes, on mutualise au moins une partie des bornes ce qui permet un gain de place sensible.

De manière avantageuse, plusieurs bornes, de manière encore plus avantageuse toutes les bornes, sont mutualisées entre des dispositifs MEMS et/ou NEMS adjacents.

Dans un exemple chaque dispositif MEMS et/ou NEMS mutualise une borne avec un dispositif MEMS et/ou NEMS adjacent et les bornes d'un même dispositif MEMS et/ou NEMS mutualise ses bornes avec différents dispositifs MEMS et/ou NEMS adjacents.

Ainsi, au lieu d'avoir des dispositifs MEMS et/ou NEMS disposés les uns à côtés des autres dont l'empreinte est géométriquement distincte de celle des dispositifs NEMS et/ou MEMS adjacents, les empreintes des dispositifs MEMS et/ou NEMS sur le support se chevauchent partiellement.

Les zones d'interaction sont propres à chaque dispositif et chaque dispositif NEMS et/ou MEMS a au moins une borne mutualisée.

De manière très avantageuse, le réseau de dispositifs MEMS et/ou NEMS est connecté par un substrat de type CMOS pour Complementary Metal Oxide Semiconductor en terminologie anglo-saxonne en utilisant les niveaux d'interconnections du circuit CMOS, comprenant plusieurs niveaux de métal et des vias pour assurer le routage des signaux, ces niveaux étant situés au-dessus du CMOS. Ces niveaux d'interconnexions sont appelés BEOL pour Back End of Line en terminologie anglo-saxonne comportant plusieurs niveaux de métallisations.

La présente invention a alors pour objet un système microélectronique et/ou nanoélectronique comportant n dispositifs microélectromécaniques et/ou nanoélectromécaniques, dits dispositifs, n étant supérieur ou égal à 2, disposés sur un support de connexion destiné à connecter électriquement les n dispositifs, chacun des dispositifs comportant une zone d'interaction, au moins un ancrage mécanique, au moins une première borne électrique destinée à récupérer un signal émis par chaque dispositif représentatif de l'état de la zone d'interaction, au moins une deuxième borne électrique et une troisième borne électrique, chaque borne ayant une fonction donnée. Parmi les n dispositifs, au moins une partie des dispositifs est disposée de telle sorte que l'emplacement géométrique d'au moins une des bornes parmi les première, deuxième et troisième bornes d'un des dispositifs adjacents est identique à l'emplacement géométrique de l'autre borne dudit autre dispositif adjacent ayant la même fonction, lesdites bornes desdits deux dispositifs adjacents étant confondues.

Dans la présente demande, on entend par « support de connexion » toute structure comportant des routages électriques permettant de connecter les dispositifs entre eux et/ou à un dispositif extérieur. A titre d'exemple ce support peut-être un interposeur électrique, des lignes de conductrice dans un substrat, une structure CMOS....

De préférence, les dispositions relatives des première, deuxième et troisième bornes, de la zone d'ancrage et de la zone d'interaction sont identiques ou similaires pour les n dispositifs,
Selon l'invention, parmi les n dispositifs, au moins une partie des dispositifs est disposée de telle sorte que les ancrages mécaniques de deux dispositifs adjacents sont confondus, l'emplacement géométrique de l'ancrage mécanique d'un desdits dispositifs adjacents étant identique à l'emplacement géométrique de l'ancrage mécanique de l'autre desdits dispositifs adjacents.

Dans un exemple encore plus avantageux, parmi les n dispositifs, au moins une partie des dispositifs est disposée de telle sorte que la première et/ou la deuxième (c) et/ou la troisième borne (a) de deux dispositifs adjacents sont confondues, l'emplacement géométrique de la première et/ou de la deuxième et/ou de la troisième borne de l'un des dispositifs adjacentes étant identique à l'emplacement géométrique de la première et/ou de la deuxième et/ou de la troisième borne l'autre desdits dispositif adjacent respectivement.

Par exemple, les zones d'interaction s'étendent chacune selon une direction longitudinale, les dispositifs étant disposés de sorte que les directions longitudinales des zones d'interaction soient confondues ou parallèles. La première borne et l'ancrage mécanique peuvent être disposés chacun à une extrémité longitudinale de la zone d'interaction, les deuxièmes et troisièmes bornes étant disposées latéralement par rapport à la zone d'interaction.

De préférence, les dispositifs sont disposés sur le support selon une répartition en ligne et en colonne, la première borne d'un dispositif étant confondue avec une première borne d'un dispositif adjacent qui est différent de celui comportant l'ancrage mécanique avec lequel l'ancrage mécanique dudit dispositif est confondu.

Dans un exemple de réalisation, la première borne d'un dispositif est confondue avec une première borne d'un dispositif adjacent qui est différent de celui comportant la deuxième et/ou la troisième borne avec lesquels la deuxième borne et/ ou la troisième borne sont confondues.

Le système peut comporter une quatrième et une cinquième bornes, la deuxième et la troisième bornes étant disposées d'un côté de la zone d'interaction et la quatrième et la cinquième bornes étant disposées de l'autre côté de la zone d'interaction.

De manière très avantageuse, les deuxième et troisième bornes sont confondues respectivement avec les deuxième et troisième bornes du même dispositif adjacent et les quatrième et cinquième bornes étant confondues avec les quatrième et cinquième bornes d'un dispositif adjacent différent de celui avec lequel ledit dispositif a ses deuxième et troisième bornes confondues.

De manière préférée, les n dispositifs sont adressables individuellement et connectés par le support de connexion. Les dispositifs peuvent être connectés en parallèle ou en série.

Dans un exemple de réalisation, les dispositifs sont de type résonant, la zone d'interaction étant portée par un élément suspendu destiné à être mis en vibration et la deuxième et/ou la quatrième borne alimente(nt) des moyens d'excitation de la zone d'interaction, chaque dispositif ayant une fréquence de résonance propre.

En fonction des applications, la fréquence de résonance peut-être différente pour chaque dispositif ou identique pour tout ou partie d'entre eux

La troisième et/ou la cinquième borne sont par exemple connectées à des moyens de détection du déplacement de la zone d'interaction. Une jauge piézorésistive peut relier l'élément d'interaction et la troisième borne et/ou une jauge piézorésistive peut relier l'élément d'interaction et la cinquième borne.

Par exemple, le support de connexion comporte un ou plusieurs niveaux de connexion relié aux bornes par des vias.

Le support est par exemple de type CMOS.

La présente invention a également pour objet un système d'analyse d'un milieu, comportant un système de dispositifs MEMS et/ou NEMS selon l'invention et une unité de commande connectée aux dispositifs par le support de connexion.

Dans un exemple, le milieu à analyser est liquide et l'analyse porte sur des cellules biologiques contenues dans ledit milieu liquide.

Dans un autre exemple, le milieu à analyser est gazeux et l'analyse porte sur des particules contenues dans ledit milieu gazeux.

La présente invention a également pour objet un système d'actionnement, comportant un système de dispositifs MEMS et/ou NEMS selon l'invention et une unité de commande connectée aux dispositifs par le support de connexion.

### BRÈVE DESCRIPTION DES DESSINS

La présente invention sera mieux comprise sur la base de la description qui va suivre et des dessins en annexe sur lesquels:
- la figure 1 est une vue de dessus représentée schématiquement d'un dispositif MEMS et/ou NEMS pouvant être mis en en oeuvre dans un système selon l'invention,
- la figure 2 est une vue de dessus d'un réseau de dispositifs MEMS et/ou NEMS dans un exemple de réalisation très avantageux de l'invention,
- les figures 3A et 3B sont des vues de dessus d'autres exemples de réalisation d'un réseau de dispositifs MEMS et/ou NEMS,
- les figures 4A et 4B sont des vues de dessus et en coupe respectivement d'un circuit CMOS comportant les interconnexions du réseau de dispositifs MEMS et /ou NEMS,
- les figures 5A à 5C sont des représentations schématiques de l'assemblage du circuit CMOS des figures 4A et 4B et d'un substrat dans lequel est destiné à être réalisé le réseau de dispositifs de MEMS et/ou NEMS,
- les figures 6A à 6E' sont des représentations schématiques de vue de dessus et de côté de différentes étapes de réalisation du réseau de dispositifs MEMS et/ou NEMS et de l'interconnexion des dispositifs MEMS et/ou NEMS,

### EXPOSÉ DÉTAILLÉ DE MODES DE RÉALISATION PARTICULIERS

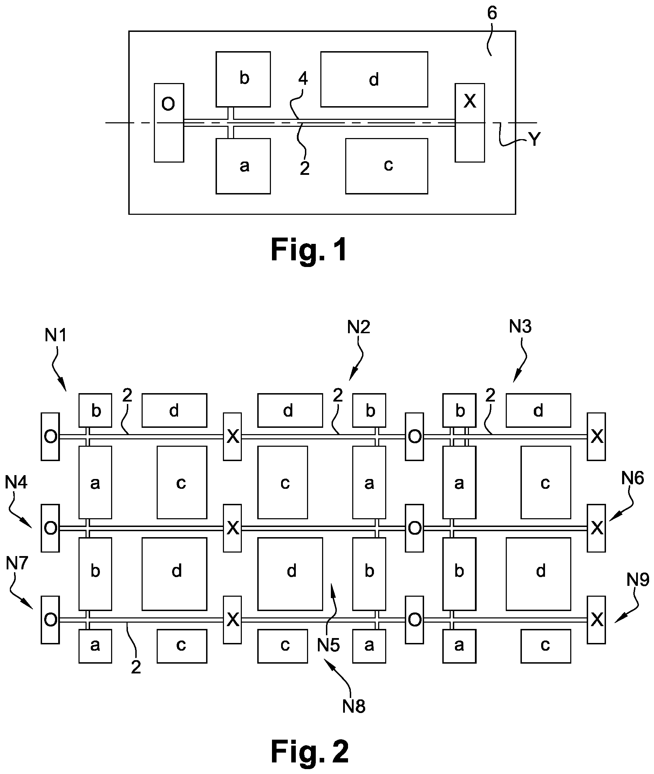

Sur la figure 1 on peut voir un exemple d'un dispositif MEMS et/ou NEMS pouvant être mis en oeuvre dans la réalisation d'un système ou réseau de dispositifs MEMS et/ou NEMS. A des fins de simplicité, un dispositif MEMS et/ou NEMS sera désigné par « NEMS ».

Le NEMS comporte un élément d'interaction portant une zone d'interaction 2 et des bornes a, b, c, d, O et X. Dans l'exemple représenté, l'élément d'interaction est destiné à être mobile, le NEMS étant du type à résonant. Lorsqu'une ou des particules viennent s'adsorber ou s'absorber sur la zone d'interaction, la fréquence de résonance mécanique varie, c'est la détection de cette variation qui permet d'atteindre la masse et les type de particules. La zone d'interaction est par exemple portée par une poutre ou une membrane 4 suspendue par rapport à un support 6.

En variante, au lieu que des particules ou molécules se déposent sur la zone d'interaction, on peut mesurer une variation de la conductivité du milieu ambiante, par exemple due à la variation de composition du milieu environnant, cette variation de conductivité induisant une variation de fréquence de résonance. En variante encore, on peut mesurer une variation du potentiel électrostatique environnant, par exemple due à l'adsorption d'une particule ionisée, cette variation du potentiel électrostatique induisant une variation de fréquence de résonance.

Les bornes servent au fonctionnement du NEMS et son intégration dans le réseau.

La borne X est disposée à une extrémité longitudinale de la poutre 4. La borne X est destinée principalement à l'ancrage mécanique de l'élément d'interaction sur le support 6. Elle peut également avoir une fonction électrique.

Les bornes O, a, b, c et d sont des bornes électriques.

La borne O est disposée à l'extrémité longitudinale de la poutre à l'opposé de la borne X. La borne O forme la sortie du signal de détection par la zone d'interaction.

Les bornes c et d sont disposées latéralement par rapport à l'axe longitudinal Y de la poutre de part et d'autre de l'axe longitudinal Y. Les bornes c et d forment des électrodes qui, avec les faces latérales de la poutre, forment des moyens de d'actionnement ou d'excitation capacitifs, capables de mettre en vibration à sa fréquence de résonance mécanique. Les bornes a et b sont disposées latéralement par rapport à l'axe longitudinal Y de la poutre de part et d'autre de l'axe longitudinal Y. Les bornes a et b sont reliées mécaniquement à la poutre par des jauges piézorésistives, avantageusement des nanojauges piézorésistives, les bornes a et b assurent la polarisation des nanojauges. En variante une seule jauge pourrait être mise en oeuvre.

Lorsque l'on souhaite lire la réponse de l'un des NEMS, le signal de sortie collecté à la borne O comporte le signal amplifié dudit NEMS et les signaux de tous les autres NEMS qui forment un bruit. L'adressage et le fonctionnement d'un réseau de NEMS résonants est décrit dans le document *"*FREQUENCY-ADDRESSED NEMS ARRAYS FOR MASS AND GAS SENSING APPLICATIONS", E. Sage, O. Martin, C.Dupré, T.Ernst, G.Billiot, L.Duraffourg, E. Colinet and S. Hentz, CEA, LETI, MINATEC Campus, 17 rue des Martyrs, 38054 GRENOBLE Cedex 9, France. Transducers 2013 16/06/2013 - 20/06/2013 Barcelone Espagne*.*

Il sera compris que le nombre de bornes n'est pas limitatif, il pourrait être inférieur à 6 ou supérieur à 6.

Tout dispositif qui est apte à être distingué des autres dispositifs autrement que par sa localisation géographique et les connexions électriques peut être mis en oeuvre pour réaliser un réseau à forte densité selon l'invention. Par exemple, on peut mettre en oeuvre des NEMS dont on mesure la variation de résistance électrique par exemple de type piézorésisitif ou dont on mesure une variation de capacité. Chaque NEMS présente une résistance initiale ou une capacité initiale différente des résistances ou capacités des autres NEMS.

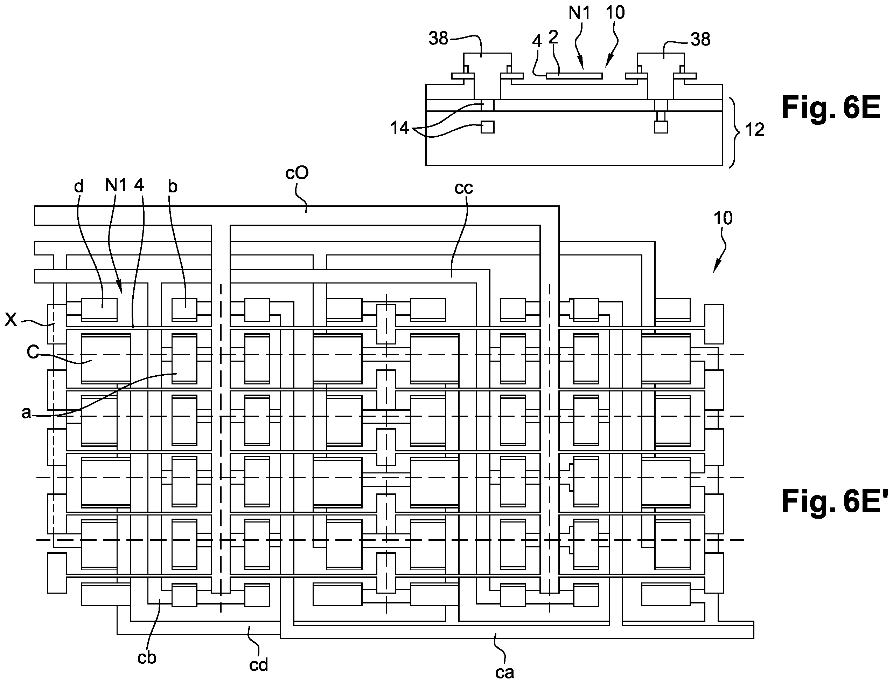

Sur la figure 6E, on peut voir une représentation schématique d'un système de NEMS selon l'invention. Il comporte un empilement comprenant un réseau de NEMS 10 et un substrat support de connexion 12 du réseau de NEMS, le réseau de NEMS comportant des interconnexions 14 des NEMS connectant les NEMS en parallèle.

Le réseau 10 comporte une pluralité de NEMS disposés en lignes et en colonnes. Tous les NEMS présentent la même disposition relative des bornes a, b, c, d et O et X par rapport à la zone d'interaction et les uns par rapport aux autres.

En outre l'élément d'interaction peut être mis en mouvement hors-plan, en particulier dans le cas où le NEMS est utilisé en tant qu'actionneur.

Les NEMS peuvent être tous adressables individuellement. Dans le mode de réalisation dans lequel les NEMS sont de type résonant, chaque NEMS a sa propre fréquence de résonance distincte de celles des autres NEMS ce qui permet de les différencier. La fréquence de résonance est par exemple fixée par les dimensions des NEMS, par exemple par les dimensions de l'élément d'interaction, par la raideur de l'élément d'interaction et ou de ses moyens de suspension... Les NEMS ont par exemple tous des dimensions différentes. Dans le cas de NEMS comportant des poutres, puisque la fréquence d'une poutre est proportionnelle au rapport de la largeur vibrante sur la longueur au carré, on peut réaliser des NEMS ayant chacun une longueur de poutre différente de celle des poutres des autre NEMS.

En variante, on peut envisager que les NEMS soient adressables par groupe, chaque groupe ayant par exemple la même fréquence de résonance.

Sur la figure 2, on peut voir exemple de disposition particulièrement avantageuse des NEMS selon l'invention. Les NEMS sont disposés de sorte que les bornes remplissant les mêmes fonctions puissent être communes à deux NEMS adjacents. Dans l'exemple très avantageux de la figure 2, toutes les bornes pouvant être mutualisées le sont afin de réduire au maximum la place non utilisée entre les NEMS et augmenter la densité surfacique de NEMS.

A la fois les bornes électriques O, a, b, c et d sont mutualisées mais également les bornes mécaniques X.

Le réseau de la figure 2 comporte 9 NEMS désignés N1 à N9, les NEMS N1 à N3 sont sur la première ligne, les NEMS N4 à N6 sont sur la deuxième ligne et les NEMS N7 à N9 sont sur la troisième ligne.

De manière avantageuse, les NEMS sont disposés de sorte que deux bornes communes de même type soient l'une à côté de l'autre pour simplifier l'interconnexion.

Dans l'exemple représenté, les NEMS N1 et N2 ont en commun la borne X et les NEMS N1 et N4 ont en commun les bornes a et c.

Le NEMS N5 a ses bornes a et c en commun avec le NEMS N2, a ses bornes b et d en commun avec le NEMS N8, sa borne O en commun avec N7 et sa borne X en commun avec N4, il partage donc toutes ses bornes.

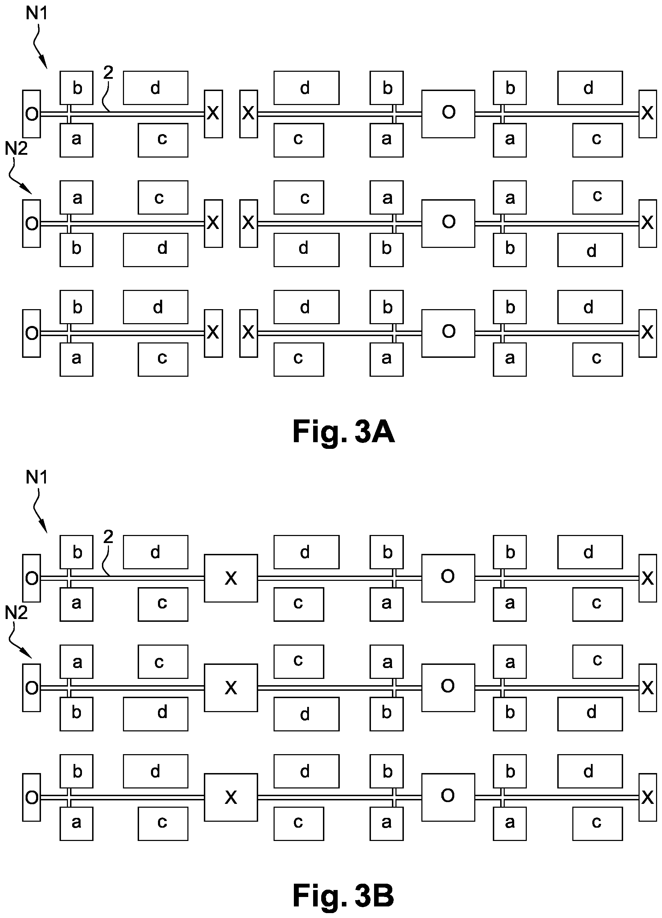

Sur la figure 3A, on peut voir un autre exemple de réseau dans lequel les NEMS ont uniquement en commun leur borne O. Chaque NEMS partage la borne O avec un NEMS voisin. Dans l'exemple représenté, ce sont les NEMS disposés sur une même ligne.

On peut prévoir de manière avantageuse que les NEMS mutualisent les bornes O et X comme on peut le voir sur la figure 3B.

Dans les exemples des figures 3A et 3B, les NEMS sont disposés les uns par rapport aux autres de sorte que deux bornes de deux NEMS adjacents ayant la même fonction sont en regard, mais il sera compris que cette disposition n'est pas limitative, par exemple une borne a pourrait être en regard d'une borne b et une borne c pourrait être en regard d'une borne d.

De manière encore plus avantageuse, les NEMS mutualisent également au moins l'une de leurs bornes a, b, c ou d voire plusieurs.

De manière préférée, comme cela a été décrit toutes les bornes sont mutualisées (figure 2).

Comme on peut le voir sur la figure 2, les NEMS disposés sur l'extérieur du réseau possèdent des bornes situées à l'extérieur qui ne sont pas mutualisées. Les bornes b et d des NEMS N, N2, N3 ne sont pas mutualisées, les bornes a et c des NEMS N6, N7 et N8 ne sont pas mutualisées, les bornes O des NEMS N1, N4, N7 ne sont pas mutualisées et les bornes X des NEMS N3, N6, N9 ne sont pas mutualisées.

On peut prévoir également de mutualiser certaines des bornes extérieures par exemple, en considérant la représentation de la figure 2, on peut prévoir de mutualiser les bornes d et/ou les bornes b situés sur le bord extérieur supérieur du réseau et/ou les bornes a et/ou les bornes c situés sur le bord extérieur inférieur du réseau, par exemple en réduisant la taille des bornes X et O et/ou en modifiant le dimensionnement des bornes b et d.

Nous allons maintenant décrire un exemple d'un support de connexion 12 permettant de relier électriquement les bornes a, b, c, d, et O mutualisées ou non à une unité de commande. De manière très avantageuse, le support de connexion est un BEOL d'un substrat CMOS, le BEOL ou Back end of the line en terminologie anglo-saxonne est la partie comportant les interconnexions entre les différents dispositifs portés par le circuit intégré ou le système. Dans le cas présent, le BEOL comporte les interconnexions des NEMS, en parallèle ou en série, du réseau en vue d'une connexion vers une unité de commande

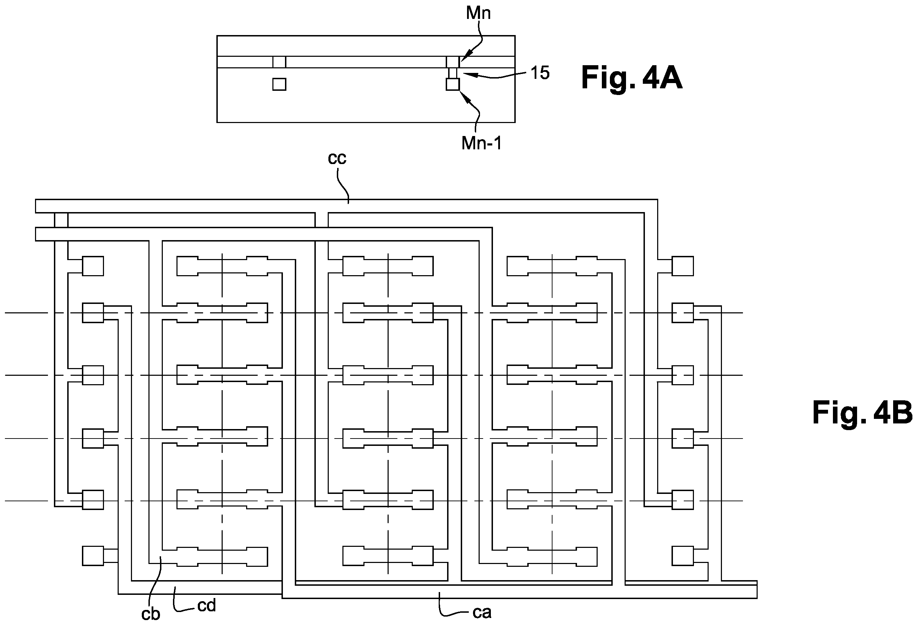

Sur la figure 4A, on peut voir un vue en coupe d'un exemple de BEOL et sur la figure 4B on peut voir une vue de dessus des pistes conductrices du BEOL assurant une connexion en parallèle des NEMS, plus précisément assurant une connexion en parallèle de chaque borne a, b, c, d d'un NEMS avec les bornes a, b, c, d des autres NEMS du réseau respectivement. Comme nous le verrons par la suite la connexion en parallèle des bornes O est réalisée lors de la réalisation des NEMS, mais ceci n'est en aucun cas limitatif et elle pourrait également être réalisée dans le BEOL.

Les interconnexions sont réparties dans deux niveaux Mn et Mn-1, le niveau Mn-1 étant celui situé le plus près de la face libre 4 du BEOL sur laquelle la couche, dans laquelle les NEMS vont être réalisés, sera formée.

Les niveaux Mn et Mn-1 sont des niveaux de métallisation dans lesquels sont structurées les connexions ca, cb, cc, cd, destinées à interconnectées les bornes, a, b, c, d respectivement.

De manière avantageuse, on réalise plusieurs types de connexion dans un même niveau de métallisation de sorte à réduire le nombre de niveaux de métallisation. De manière avantageuse, les connexions ca et cb sont réalisées dans le niveau Mn et les connexions cc et cd sont réalisées dans le niveau Mn-1. Il est possible de réaliser les connexions ca et cb dans le même niveau car les connexions ne se croisent pas comme on peut le voir sur la figure 4B, de même pour les connexions cc et cd.

Dans l'exemple représenté, toutes les bornes b sont interconnectées par une seule connexion, mais on pourrait prévoir de mettre en oeuvre plusieurs connexions du même type.

De manière très avantageuse, toutes les connexions ca, cb, cc, cd ont la même configuration, mais leurs orientations sont différentes. Le procédé de réalisation est alors simplifié. Mais il sera compris que des connexions avec des configurations différentes les unes des autres ne sortent pas du cadre de la présente invention.

Dans l'exemple représenté, chaque connexion interconnecte les bornes de 20 NEMS.

En variante, on pourrait prévoir trois niveaux de métallisation, deux niveaux n'ayant qu'un seul type de connexion, voire quatre niveaux de métallisation chaque niveau ayant un seul type de connexion.

Dans l'exemple représenté, des connexions verticales ou vias 15 sont réalisées dans le niveau Mn en vue de connecter ultérieurement le niveau Mn-1 et les bornes c et d des NEMS. Ces vias ne connectent pas électriquement les connexions ca, cb du niveau Mn aux connexions cc, cd du niveau Mn-1.

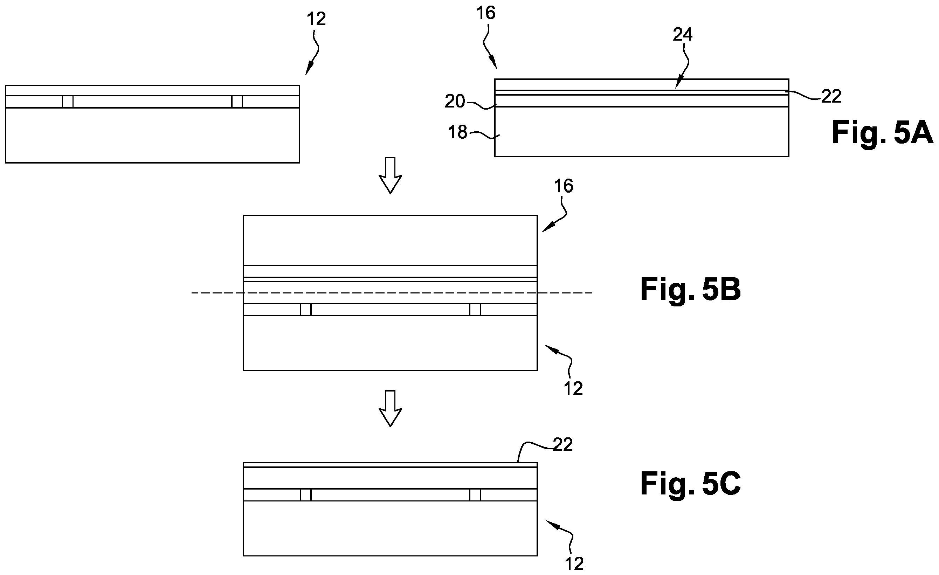

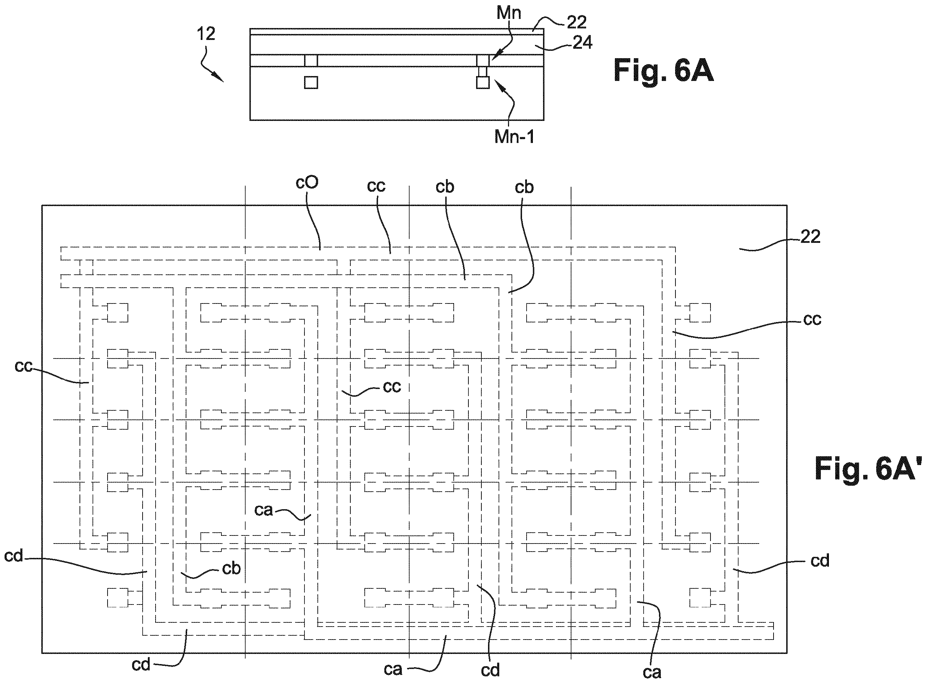

Un exemple de procédé de réalisation d'un système comportant un réseau ayant la configuration de la figure 2 va maintenant être décrit en relation avec les figures 5A à 5C et 6A à 6D'.

De manière préférée, lors d'une première étape le support de connexion 12 est réalisé, il s'agit de préférence d'un BEOL tel que décrit sur les figures 4A et 4B. chaque niveau d'interconnexion du BEOL peut être obtenu en structurant des lignes de métal, en remplissant d'oxyde, plus généralement d'un matériau diélectrique, les zones entre les lignes et en réalisant des vias pour effectuer les reprises de contact. Le niveau d'interconnexion suivant est réalisé de la même manière. Celui-ci est représenté schématiquement sur la figure 5A.

Lors d'une étape suivante on assemble le support de connexion 12 et un substrat 16 dans une couche duquel seront réalisés les NEMS. De préférence, il s'agit d'un substrat de type isolant sur silicium ou SOI ou (Silicon on insulator en terminologie anglo-saxonne) (figure 5A). Le substrat comporte un substrat épais 18, une couche de matériau diélectrique 20 tel qu'un oxyde et une couche de silicium monocristallin 22 en face avant.

En variante le substrat 16 peut être un substrat massif, par exemple en diamant, qui est ensuite aminci.

Lors d'une étape suivante, le substrat support de connexion 12 et le substrat SOI 16 sont assemblés par exemple par collage par oxyde TEOS de sorte que la couche de silicium 22 est en regard du BEOL. Les deux faces à coller comporte de l'oxyde (par exemple TEOS pour orthosilicate de tétraéthyle) planarisé par polissage physico-chimique pour une bonne planéité. Puis les deux faces sont collées par scellement moléculaire

L'élément ainsi obtenu est représenté sur la figure 5B.

Lors d'une étape suivante, on réalise un amincissement du substrat 16 par sa face arrière de sorte à supprimer le substrat épais 18 et la couche d'oxyde 20. L'amincissement est par exemple réalisé par gravure sèche ou humide, puis par polissage physico-chimique.

La couche de silicium 22 est séparée du BEOL par l'interface de collage 24.

La couche de silicium monocristallin 22 est en face avant de l'assemblage.

L'élément ainsi obtenu est représenté sur la figure 5C.

Nous allons maintenant décrire la réalisation des NEMS dans la couche 22.

Sur la figure 6A, on peut voir de manière détaillée l'élément de la figure 5C.

Sur la figure 6A', on peut voir représenté de manière schématique une vue de dessus de l'élément de la figure 6A, les connexions ca, cb, cc, cd étant visibles par transparence à travers la couche 22.

Lors d'une étape suivante, on réalise une structuration de la couche 22 de sorte à réaliser les NEMS dans la couche 22. La structuration de la couche 22 est réalisée par des techniques classiques de la microélectronique et nanoélectronique par des étapes de dépôts de masques, photo lithogravures par exemple optique ou électronique et de libération.

Simultanément on réalise la connexion cO. En variante la connexion cO pourrait être réalisée dans le support de connexion par exemple dans un niveau Mn-2, les bornes O seraient alors connectées à la connexion cO par des vias de manière similaires aux bornes a, b, c, d.

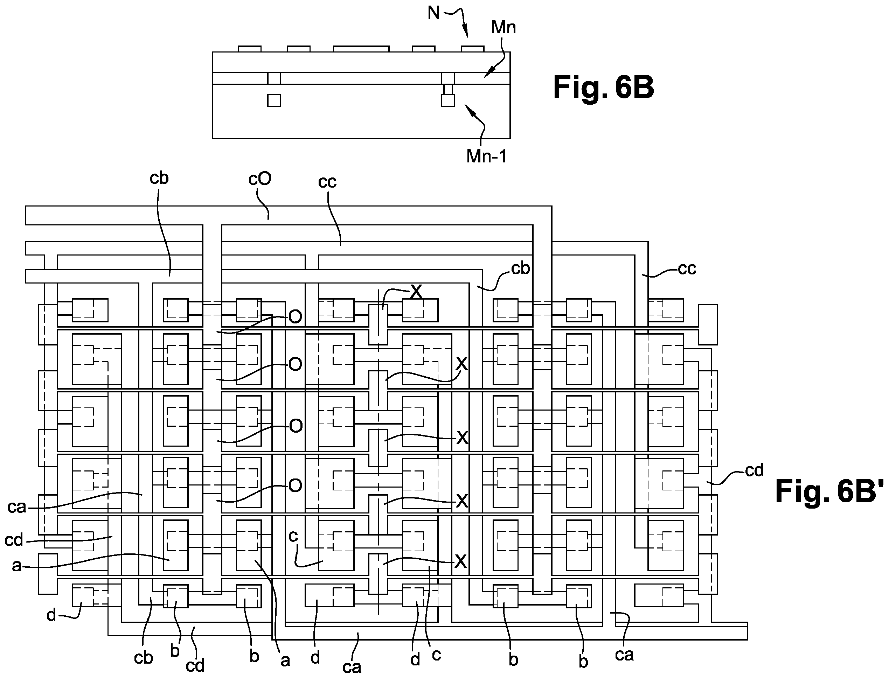

L'élément ainsi obtenu est représenté sur les figures 6B et 6B'. Sur la figure 6B', on peut voir les NEMS individualisés. A cette étape de réalisation, les NEMS ne sont pas reliées électriquement aux connexions ca, cb, cc, cd comme on peut le voir sur la figure 6B.

Lors d'une étape suivante, on forme une couche de passivation 28 sur les NEMS, par exemple en oxyde TEOS et on ouvre cette couche avec arrêt sur le silicium des NEMS pour définir les emplacements des via et du routage de la couche de métallisation.

Lors d'une étape suivante, on relie électriquement les différentes bornes des NEMS aux connexions ca, cb, cc, cd au moyen de vias au travers de l'interface de collage 24.

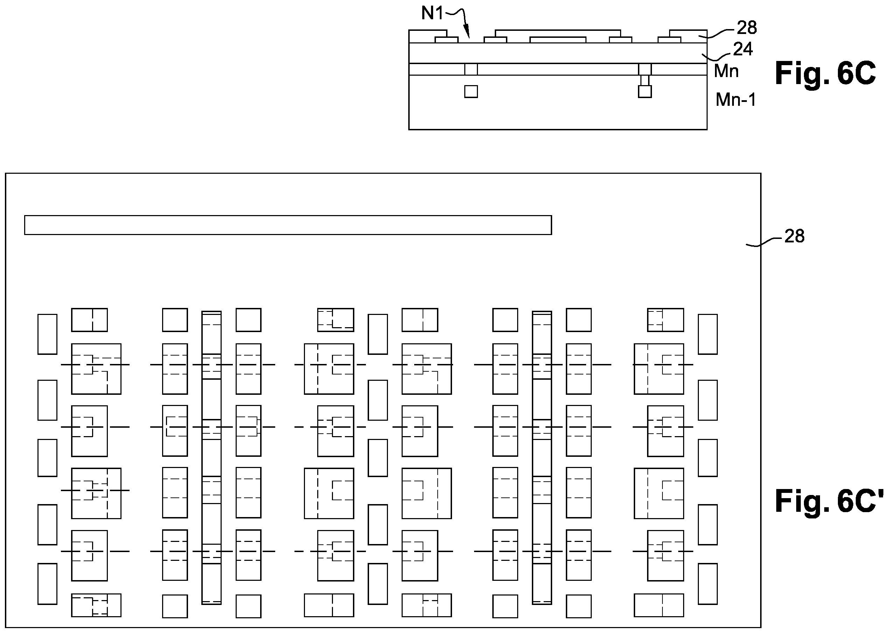

L'élément ainsi obtenu est représenté sur les figures 6C et 6C'.

Lors d'une étape suivante, on réalise tout d'abord des cavités 30, 32, 34, 36 dans les bornes a, b, c, d respectivement jusqu'aux connexions ca, cb, cc, cd. Dans le cas des bornes c et d à connecter aux connexions cc et cd situées dans le niveau Mn-1, les cavités 34 et 36 débouchent sur les vias 15. Pour cela on grave la couche d'interface 24.

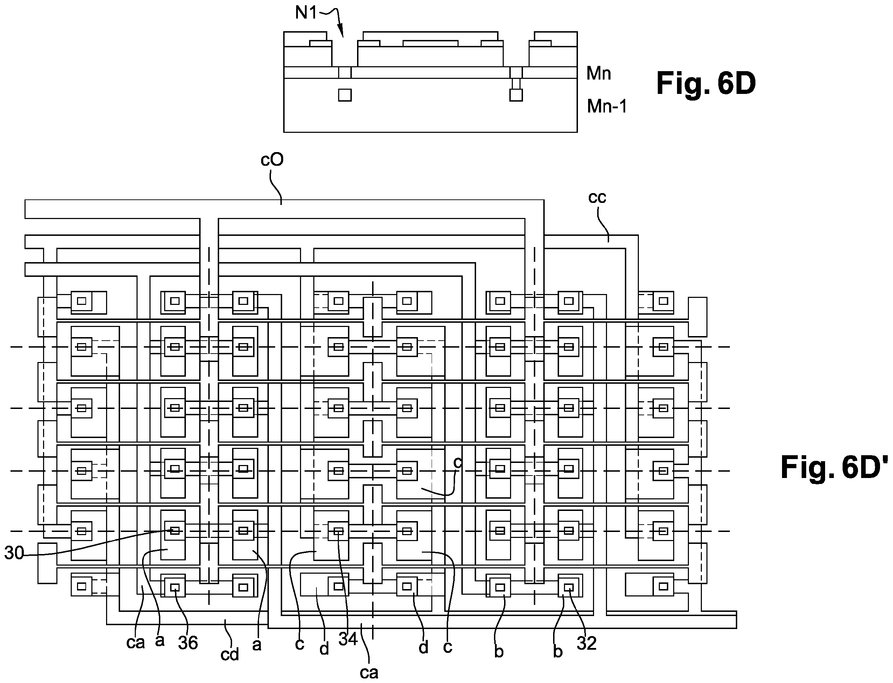

L'élément ainsi obtenu est représenté sur les figures 6D et 6D'. Sur la figure 6D', la couche 28 n'est pas représentée.

Lors d'une étape suivante, on réalise une couche de métal, par exemple du Cu, TiN/Ti, WSi, AISi, Ni, pour réaliser le contact entre le fond des via et les NEMS de sorte relier électriquement les bornes a, b, c, d et les connexions ca, cb, cc, cd. La couche métallique est ensuite structurée pour ne la conserver qu'un niveau des vias. Ensuite on effectue une gravure des couches 24 et 28, par exemple à l'acide fluorhydrique.

En variante, on pourrait ne pas réaliser les vias 15 et assurer la reprise de contact le niveau Mn-1 par les vias 38 directement.

L'élément ainsi obtenu est représenté sur les figures 6E et 6E'. Sur la figure 6E', la couche de passivation n'est pas représentée.

Comme cela a été mentionné ci-dessus, les NEMS pourraient comporter plus de 6 bornes. Par exemple ils pourraient comporter 8 bornes indépendantes, sui seraient connectées par exemple en utilisant un BEOL avec un ou deux niveaux supplémentaires de connexion, des vias traversant les différents niveaux connectant les connexions et les bornes.

Grâce à l'invention, on obtient alors un système comportant une grande densité de NEMS mis en réseau et adressables individuellement.

Le système peut avantageusement servir à des analyses d'un milieu environnant, chaque NEMS étant un capteur. On peut par exemple prévoir de former un capot par-dessus les NEMS de sorte à définir une chambre d'analyse ou un canal fluidique.

Alternativement, les NEMS pourraient former chacun un actionneur, par exemple pour déplacer des cellules ou leur appliquer un effort et mesurer leur raideur.

Grâce à l'invention, on peut réaliser des NEMS couvrant environ 10% de surface active, alors qu'avec le réseau décrit dans le document *"*FREQUENCY-ADDRESSED NEMS ARRAYS FOR MASS AND GAS SENSING APPLICATIONS", E. Sage, O. Martin, C.Dupré, T.Ernst, G.Billiot, L.Duraffourg, E. Colinet and S. Hentz, CEA, LETI, MINATEC Campus, 17 rue des Martyrs, 38054 GRENOBLE Cedex 9, France. Transducers 2013 16/06/2013 - 20/06/2013 Barcelone Espagne de la technique, les NEMS couvre environ 0,1%.

## Revendications

1. Système microélectronique et/ou nanoélectronique comportant n dispositifs microélectromécaniques et/ou nanoélectromécaniques, dits dispositifs, n étant supérieur ou égal à 2, disposés sur un support de connexion (12) destiné à connecter électriquement les n dispositifs, chacun des dispositifs comportant une zone d'interaction (2), au moins un ancrage mécanique (X), au moins une première borne électrique (O) destinée à récupérer un signal émis par chaque dispositif représentatif de l'état de la zone d'interaction (2), au moins une deuxième borne électrique (c) et une troisième borne électrique (a), chaque borne ayant une fonction donnée, dans lequel, parmi les n dispositifs, au moins une partie des dispositifs est disposée de telle sorte que l'emplacement géométrique d'au moins une des bornes parmi les première, deuxième et troisième borne (O, a, c) d'un des dispositifs adjacents est identique à l'emplacement géométrique de l'autre borne dudit autre dispositif adjacent ayant la même fonction, lesdites bornes desdits deux dispositifs adjacents étant confondues, **caractérisé en ce que** dans le système, parmi les n dispositifs, au moins une partie des dispositifs est disposée de telle sorte que les ancrages mécaniques (X) de deux dispositifs adjacents sont confondus, l'emplacement géométrique de l'ancrage mécanique d'un desdits dispositifs adjacents étant identique à l'emplacement géométrique de l'ancrage mécanique de l'autre desdits dispositifs adjacents.

2. Système microélectronique et/ou nanoélectronique selon la revendication 1, dans lequel les dispositions relatives des première (O), deuxième (c) et troisième (a) bornes, de la zone d'ancrage (X) et de la zone d'interaction (2) sont identiques ou similaires pour les n dispositifs,

3. Système selon la revendication 1 ou 2, dans lequel, parmi les n dispositifs, au moins une partie des dispositifs est disposée de telle sorte que la première et/ou la deuxième (c) et/ou la troisième (a) borne de deux dispositifs adjacents sont confondues, l'emplacement géométrique de la première et/ou de la deuxième et/ou de la troisième borne de l'un des dispositifs adjacentes étant identique à l'emplacement géométrique de la première et/ou de la deuxième et/ou de la troisième borne de l'autre desdits dispositif adjacent respectivement.

4. Système selon l'une des revendications 1 à 3, dans lequel les zones d'interaction (2) s'étendent chacune selon une direction longitudinale, les dispositifs étant disposés de sorte que les directions longitudinales des zones d'interaction (2) soient confondues ou parallèles, dans lequel la première borne (O) et l'ancrage mécanique (X) étant avantageusement disposés chacun à une extrémité longitudinale de la zone d'interaction (2), les deuxièmes (c) et troisièmes (a) bornes étant disposées latéralement par rapport à la zone d'interaction.

5. Système selon l'une des revendications 1 à 4, dans lequel les dispositifs sont disposés sur le support de connexion (12) selon une répartition en ligne et en colonne, la première borne d'un dispositif étant confondue avec une première borne d'un dispositif adjacent qui est différent de celui comportant l'ancrage mécanique avec lequel l'ancrage mécanique dudit dispositif est confondu.

6. Système selon l'une des revendications 1 à 5 en combinaison avec la revendication 3, dans lequel la première borne d'un dispositif est confondue avec une première borne d'un dispositif adjacent qui est différent de celui comportant la deuxième et/ou la troisième borne avec lesquels la deuxième borne et/ ou la troisième borne sont confondues.

7. Système selon l'une des revendications 1 à 6 en combinaison avec la revendication 4, comportant une quatrième (d) et une cinquième (b) bornes, la deuxième (c) et la troisième (a) bornes étant disposées d'un côté de la zone d'interaction (2) et la quatrième (d) et la cinquième (b) bornes étant disposées de l'autre côté de la zone d'interaction (2).

8. Système selon la revendication 7, dans lequel les deuxième et troisième bornes sont confondues respectivement avec les deuxième et troisième bornes du même dispositif adjacent et les quatrième et cinquième bornes étant confondues avec les quatrième et cinquième bornes d'un dispositif adjacent différent de celui avec lequel ledit dispositif a ses deuxième et troisièmes bornes confondues.

9. Système selon l'une des revendications 1 à 8, dans lequel les n dispositifs sont adressables individuellement et connectés par le support de connexion (12), par exemple les dispositifs étant de type résonant, la zone d'interaction (2) étant portée par un élément suspendu (4) destiné à être mis en vibration et la deuxième (c) et/ou la quatrième (a) borne alimentant des moyens d'excitation de la zone d'interaction (2), chaque dispositif ayant une fréquence de résonance propre.

10. Système selon l'une des revendications 1 à 9 en combinaison avec l'une des revendications 7 et 8, dans lequel les troisième (a) et/ou la cinquième (b) bornes sont connectées à des moyens de détection du déplacement de la zone d'interaction, par exemple une jauge piézorésistive reliant l'élément d'interaction (4) et la troisième borne (a) et/ou une jauge piézorésistive reliant l'élément d'interaction (4) et la cinquième borne (b).

11. Système selon l'une des revendications 1 à 10, dans lequel le support de connexion comporte au moins un niveau de connexion (Mn, Mn-1) relié aux bornes (O, a, b, c, d) par des vias, avantageusement le support de connexion (12) comportant plusieurs niveaux de connexions (Mn, Mn-1) reliés aux bornes (O, a, b, c, d) par des vias

12. Système selon la revendication 11, dans lequel le support est de type CMOS.

13. Système d'analyse d'un milieu, comportant un système selon l'une des revendications 1 à 12 et une unité de commande connectée aux dispositifs par le support de connexion.

14. Système d'analyse selon la revendication 13, dans lequel le milieu à analyser est liquide et l'analyse porte sur des cellules biologiques contenues dans ledit milieu liquide ou le milieu à analyser est gazeux et l'analyse porte sur des particules contenues dans ledit milieu gazeux.

15. Système d'actionnement, comportant un système selon l'une des revendications 1 à 12 et une unité de commande connectée aux dispositifs par le support de connexion.

## Patentansprüche

1. Mikroelektronisches und/ oder nanoelektronisches System, n mikroelektromechanische und/ oder nanoelektromechanische Vorrichtungen, Vorrichtungen genannt, umfassend, wobei n größer oder gleich 2 ist, die auf einem Verbindungsträger (12) angeordnet sind, der dazu bestimmt ist, die n Vorrichtungen elektrisch zu verbinden, wobei jede der Vorrichtungen eine Interaktionszone (2), zumindest eine mechanische Verankerung (X), zumindest einen ersten elektrischen Anschluss (O), der dazu bestimmt ist, ein Signal abzurufen, das durch jede Vorrichtung ausgegeben wird, die repräsentativ für den Zustand der Interaktionszone (2) ist, umfasst, zumindest einen zweiten elektrischen Anschluss (c) und einen dritten elektrischen Anschluss (a), wobei jeder Anschluss eine gegebene Funktion aufweist, bei der unter den n Vorrichtungen zumindest ein Teil der Vorrichtungen derart angeordnet ist, dass die geometrische Lage von zumindest einem der Anschlüsse unter dem ersten, zweiten und dritten Anschluss (O, a, c) einer der angrenzenden Vorrichtungen gleich der geometrischen Lage des anderen Anschlusses der anderen angrenzenden Vorrichtung ist, welche dieselbe Funktion aufweist, wobei die Anschlüsse der beiden angrenzenden Vorrichtungen zusammengenommen sind, **dadurch gekennzeichnet, dass** in dem System unter den n Vorrichtungen zumindest ein Teil der Vorrichtungen derart angeordnet ist, dass die mechanischen Verankerungen (X) von zwei angrenzenden Vorrichtungen zusammengenommen sind wobei die geometrische Lage der mechanischen Verankerung einer der angrenzenden Vorrichtungen gleich der geometrischen Lage der mechanischen Verankerung der anderen der angrenzenden Vorrichtungen ist.

2. Mikroelektronisches und/ oder nanoelektronisches System nach Anspruch 1, wobei die Anordnungen zueinander des ersten (O), zweiten (c) und dritten (a) Anschlusses der Verankerungszone (X) und der Interaktionszone (2) für die n Vorrichtungen gleich oder ähnlich sind.

3. System nach Anspruch 1 oder 2, wobei unter den n Vorrichtungen zumindest ein Teil der Vorrichtungen derart angeordnet ist, dass der erste und/ oder der zweite (c) und/ oder der dritte (a) Anschluss von zwei angrenzenden Vorrichtungen zusammengenommen sind, wobei die geometrische Lage des ersten und/ oder des zweiten und/ oder des dritten Anschlusses der einen der angrenzenden Vorrichtungen gleich der geometrischen Lage des ersten und/ oder des zweiten und/ oder des dritten Anschlusses der anderen der jeweils angrenzenden Vorrichtung ist.

4. System nach einem der Ansprüche 1 bis 3, wobei sich die Interaktionszonen (2) jeweils in eine Längsrichtung erstrecken, die Vorrichtungen derart angeordnet sind, dass die Längsrichtungen der Interaktionszonen (2) zusammengenommen oder parallel sind, wobei der erste Anschluss (O) und die mechanische Verankerung (X) vorteilshalber jeweils an einem Längsende der Interaktionszone (2) angeordnet sind, wobei der zweite (c) und dritte (a) Anschluss im Verhältnis zu der Interaktionszone seitlich angeordnet sind.

5. System nach einem der Ansprüche 1 bis 4, wobei die Vorrichtungen gemäß einer Verteilung in Zeilen und Spalten auf dem Verbindungsträger (12) angeordnet sind, wobei der erste Anschluss einer Vorrichtung mit einem ersten Anschluss einer angrenzenden Vorrichtung zusammengenommen ist, die sich von jener unterscheidet, welche die mechanische Verankerung umfasst, mit der die mechanische Verankerung der Vorrichtung zusammengenommen ist.

6. System nach einem der Ansprüche 1 bis 5 in Verbindung mit dem Anspruch 3, wobei der erste Anschluss einer Vorrichtung mit einem ersten Anschluss einer angrenzenden Vorrichtung zusammengenommen ist, die sich von jener unterscheidet, die den zweiten und/ oder den dritten Anschluss umfasst, mit denen der zweite Anschluss und/ oder der dritte Anschluss zusammengenommen sind.

7. System nach einem der Ansprüche 1 bis 6 in Verbindung mit dem Anspruch 4, einen vierten (d) und einen fünften (b) Anschluss umfassend, wobei der zweite (c) und der dritte (a) Anschluss auf einer Seite der Interaktionszone (2), und der vierte (d) und der fünfte (b) Anschluss auf der anderen Seite der Interaktionszone (2) angeordnet sind.

8. System nach Anspruch 7, wobei der zweite und dritte Anschluss jeweils mit dem zweiten und dritten Anschluss derselben angrenzenden Vorrichtung zusammengenommen sind, und der vierte und fünfte Anschluss mit dem vierten und fünften Anschluss einer anderen angrenzenden Vorrichtung als jener zusammengenommen sind, mit der die Vorrichtung ihren zweiten und dritten zusammengenommenen Anschluss aufweist.

9. System nach einem der Ansprüche 1 bis 8, wobei die n Vorrichtungen einzeln adressierbar sind und durch den Verbindungsträger (12) verbunden sind, wobei die Vorrichtungen zum Beispiel in der Art resonant sind, wobei die Interaktionszone (2) durch ein hängendes Element (4) getragen wird, das dazu bestimmt ist, in Schwingung versetzt zu werden, und der zweite (c) und/ oder der vierte (a) Anschluss die Anregungsmittel der Interaktionszone (2) versorgen, wobei jede Vorrichtung eine eigene Resonanzfrequenz aufweist.

10. System nach einem der Ansprüche 1 bis 9, in Verbindung mit einem der Ansprüche 7 und 8, wobei der dritte(a) und/ oder der fünfte (b) Anschluss mit Erfassungsmitteln für die Bewegung der Interaktionszone, zum Beispiel einer piezoresistiven Lehre verbunden sind, die das Interaktionselement (4) und den dritten Anschluss (a) verknüpft, und/ oder einer piezoresistiven Lehre, die das Interaktionselement (4) und den fünften Anschluss (b) verknüpft.

11. System nach einem der Ansprüche 1 bis 10, wobei der Verbindungsträger zumindest eine Verbindungsstufe (Mn, Mn-1) umfasst, die über Durchkontaktierungen mit den Anschlüssen (O, a, b, c, d) verknüpft ist, wobei der Verbindungsträger (12) vorteilshalber mehrere Verbindungsstufen (Mn, Mn-1) umfasst, die über Durchkontaktierungen mit den Anschlüssen (O, a, b, c, d) verknüpft sind.

12. System nach Anspruch 11, wobei der Träger in der Art eines CMOS ist.

13. Analysesystem für ein Milieu, ein System nach einem der Ansprüche 1 bis 12 und eine Steuereinheit umfassend, die durch den Verbindungsträger mit den Vorrichtungen verbunden ist.

14. Analysesystem nach Anspruch 13, wobei das zu analysierende Milieu flüssig ist, und die Analyse biologische Zellen betrifft, die in dem flüssigen Milieu enthalten sind, oder das zu analysierende Milieu gasförmig ist und die Analyse Partikel betrifft, die in dem gasförmigen Milieu enthalten sind.

15. Betätigungssystem, ein System nach einem der Ansprüche 1 bis 12 und eine Steuereinheit umfassend, die durch den Verbindungsträger mit den Vorrichtungen verbunden ist.

## Claims

1. A microelectronic system comprised of n microelectromechanical or nanoelectromechanical devices, so-called devices, n being greater than or equal to 2, arranged on a connection support (12) configured to electrically connect the n devices, each device comprising an interaction area (2), at least one mechanical anchor (X), at least one first electric terminal (O) configured to recover a signal emitted by each device representative of the state of the interaction area (2), at least a second electrical terminal (c) and a third electrical terminal (a), each terminal having a given function, in which, amongst the n devices, at least some of the devices is arranged in such a way that the geometric location of at least one of the terminals among the first, second and third terminals (O, a, c) of one of the adjacent devices is identical to the geometric location of the other terminal of said other adjacent device having the same function, said terminals of said two adjacent devices being coincident, **characterized in that** in the system, among the n devices, at least some of the devices is arranged so that the mechanical anchorages (X)of the two adjacent devices are coincident, the geometric location of mechanical anchor of said adjacent devices being identical to the geometric location of the mechanical anchors of the other of said adjacent devices.

2. A microelectronic system according to claim 1, wherein the relative arrangement of the first (O), second (c) and third (a) terminals, of the anchor area (X) and the interaction area (2) are identical or similar for the n devices.

3. A system according to claim 1 or 2, in which, among the n devices, at least some of the devices are arranged so that the first and/or the second (c) and/or the third (a) terminal of two adjacent devices are coincident, the geometric location of the first and/or the second and/or the third terminal of one of the adjacent devices being identical to the geometric location of the first and/or the second and/or the third terminal of the other of said adjacent devices respectively.

4. A microelectronic system according to one of claims 1 to 3, in which interaction areas (23) each extend in a longitudinal direction, the devices being arranged so that the longitudinal directions of the interaction areas (2) are coincident or parallel, in which the first terminal (O) and the mechanical anchor (X) being advantageously each arranged at a longitudinal end of the interaction area (2), the second (c) and third (a) terminals being arranged laterally relative to the interaction area.

5. A microelectronic system according to one of claims 1 to 4, in which devices are placed on the connection support (12) according to an in line and column distribution, the first terminal of a device being coincident with a first terminal of an adjacent device that is different from the adjacent device with the mechanical anchoring with which the mechanical anchor of said device is coincident.

6. A microelectronic system according to one of claims 1 to 5 in combination with claim 3, in which the first terminal of a device is coincident with a first terminal of an adjacent device that is different from that comprising the second and/or the third terminal with which the second terminal and/or the third terminal are coincident.

7. A microelectronic system according to one of claims 1 to 6 in combination with claim 4, comprising a fourth (d) and fifth (b) terminal, the second (c) and the third (a) terminals being arranged on one side of the interaction area (2) and the fourth (d) and the fifth (2) terminals being arranged on the other side of the interaction area (2).

8. A microelectronic system according to claim 7, in which the second and third terminals are coincident respectively with the second and third terminals of the same adjacent device and the fourth and fifth terminals being coincident with the fourth and fifth terminals of an adjacent device different from the one with which said device has its second and third terminals which are coincident.

9. A microelectronic system according to one of claims 1 to 8, in which the n devices are addressable individually and connected by the connection support (12), for example the devices being resonant type, the interaction area (2) being carried by a suspended element (4) configured to be put into vibration and in which the second (c) and/or fourth (a) terminal feed the excitation means of the interaction area (2), each device having its own resonance frequency.

10. A microelectronic system according to one of claims 1 to 9 in combination with claim 7 or 8, in which the third (a) and/or fifth (b) terminals are connected to the interaction area displacement detector, for example a piezoresistive gauge connecting the interaction element (4) and the third terminal (a) and/or a piezoresistive gauge connecting the interaction element (4) and the fifth terminal.

11. A microelectronic system according to one of claims 1 to 10, in which the connection support is comprised of at least one connection level (Mn, Mn-1) connected to the terminals (O, a, b, c, d) using vias, advantageously the connection support (12) comprising several levels of connections (Mn, Mn-1) connected to the terminals (O, a, b, c, d) using vias.

12. A microelectronic system according to claim 11, in which the connection support is of type CMOS.

13. A medium analysis system, comprised of a microelectronic system according to one of claims 1 to 12 and a control unit connected to the devices by the connection support.

14. A medium analysis system according to claim 13, wherein the medium to analyse is liquid and the analysis pertains to biological cells contained in the liquid medium, or the medium to analyse is a gas and the analysis pertains to biological cells contained in the gaseous medium.

15. An actuator system, comprised of a microelectronic system according to one of claims 1 to 12 and a control unit connected to the devices by the connection support.
